# EUROPEAN PATENT APPLICATION

(11) **EP 4 779 801 A1**
(43) Date of publication of application: **22.07.2026**
(21) Application number: 24877384.8
(22) Date of filing: 14.08.2024
(51) Int. Cl.: H01Q 1/38, H01Q 21/06, H01Q 25/00, H01Q 1/48, H05K 1/02, H01Q 1/24, H05K 1/18

(54) **ANTENNA INCLUDING CONNECTOR AND ELECTRONIC DEVICE INCLUDING SAME**

(30) Priority: 10.10.2023 KR 20230134686
(71) Applicant: Samsung Electronics Co., Ltd., Suwon-si, Gyeonggi-do 16677 (KR)
(72) Inventor: LEE, Sangyoon, Suwon-si Gyeonggi-do 16677 (KR); KUM, Junsig, Suwon-si Gyeonggi-do 16677 (KR); PARK, Sanghoon, Suwon-si Gyeonggi-do 16677 (KR); KO, Seungtae, Suwon-si Gyeonggi-do 16677 (KR); LEE, Jungyub, Suwon-si Gyeonggi-do 16677 (KR)
(74) Representative: Gulde & Partner
(86) International application number: PCT/KR2024/012113
(87) International publication number: WO 2025/079845

(57) **Abstract**

This antenna module may include an antenna substrate which includes a first region having a plurality of antenna elements disposed therein and is formed of a dielectric. The antenna module may include a printed circuit board (PCB) including a first surface having a filter disposed thereon. The antenna module may include a connector disposed in a second region different from the first region of the antenna substrate and penetrating the antenna substrate of the second region between the antenna substrate and the PCB. The connector may connect the plurality of antenna elements and the PCB, and may include a conductive portion for providing signals to the plurality of antenna elements and an elastic portion surrounding the conductive portion. The conductive portion may contact to a second surface opposite to the first surface of the PCB.

## Description

### [Technical Field]

The following descriptions relate to an antenna including a connector and an electronic device including the same.

### [Background Art]

Products equipped with a plurality of antennas are being developed to increase communication performance, and equipment having a much larger number of antennas is expected to be used by using a massive multiple input multiple output (MIMO) technology. As the number of antenna elements increases in a communication device, the number of radio frequency (RF) components (e.g., transceiver, filter, power amplifier and the like) accordingly inevitably increases.

### [Disclosure]

### [Technical Solution]

An antenna module may include an antenna substrate, which is formed of a dielectric, including a first area in which a plurality of antenna elements are disposed. The antenna module may include a printed circuit board (PCB) including a first surface on which a filter is disposed. The antenna module may include a connector, disposed in a second area different from the first area of the antenna substrate and penetrating the second area of the antenna substrate, between the antenna substrate and the PCB. The connector may include a conductive portion, connecting the plurality of antenna elements and the PCB, for providing a signal to the plurality of antenna elements, and an elastic portion surrounding the conductive portion. The conductive portion may be contacted to a second surface opposite to the first surface of the PCB.

A device of a base station may include a plurality of antenna modules. The device of the base station may include a plurality of filters corresponding to the plurality of antenna modules. Each of the plurality of antenna modules may include an antenna substrate, which is formed of a dielectric, including a first area in which a plurality of antenna elements are disposed. Each of the plurality of antenna modules may include a printed circuit board (PCB) including a first surface on which a filter among the plurality of filters is disposed. Each of the plurality of antenna modules may include a connector, disposed in a second area different from the first area of the antenna substrate and penetrating the second area of the antenna substrate, between the antenna substrate and the PCB. The connector may include a conductive portion, connecting the plurality of antenna elements and the PCB, for providing a signal to the plurality of antenna elements, and an elastic portion surrounding the conductive portion. The conductive portion may be contacted to a second surface opposite to the first surface of the PCB.

### [Description of the Drawings]

FIG. 1 illustrates an example of a wireless communication environment according to embodiments.
FIG. 2A illustrates an example of a stacked structure of an electronic device according to an embodiment.
FIG. 2B illustrates an example of a connection structure of radio frequency (RF) components of an electronic device according to an embodiment.
FIG. 3 illustrates an example of an antenna module including a connector using an elastic member according to an embodiment.
FIG. 4 illustrates an example of a connector using an elastic member according to an embodiment.
FIG. 5A and FIG. 5B illustrate examples of a connection between a connector using an elastic member and an antenna substrate according to an embodiment.
FIG. 6A and FIG. 6B illustrate examples of a connection between a connector using an elastic member and a printed circuit board (PCB) on which a filter is disposed, according to an embodiment.
FIG. 7A illustrates examples of a conductive portion of a connector according to an embodiment.
FIG. 7B illustrates examples of an elastic member of a connector according to an embodiment.
FIG. 8 illustrates an example of an antenna module including a plurality of connectors according to an embodiment.
FIG. 9A and FIG. 9B illustrate examples of a connection between an antenna module including a connector using an elastic member and a component according to an embodiment.
FIG. 10 illustrates examples of components of an electronic device according to an embodiment.

### [Mode for Invention]

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example. However, since the various embodiments of the present disclosure include technology that uses both hardware and software, the various embodiments of the present disclosure do not exclude a software-based approach.

A term referring to a component of an electronic device (e.g., a substrate, a print circuit board (PCB), a flexible PCB (FPCB), a connector, a module, an antenna, an antenna element, a circuit, a processor, a chip, a component, a device), a term referring to a shape of a component (e.g., a structure, a structure object, a support portion, a contact portion, a protrusion), a term referring to a connection portion between structures (e.g., a connection portion, a contact portion, a support portion, a conductive member, an assembly), and a term referring to a circuit (e.g., a PCB, an FPCB, a signal line, a feeding line, a transmission line, a transmission path, a data line, an RF signal line, an antenna line, an RF path, an RF module, an RF circuit, a splitter, a divider, a coupler, a combiner), used in the following description, are exemplified for convenience of description. Therefore, the present disclosure is not limited to terms to be described below, and another term having an equivalent technical meaning may be used. In addition, a term such as '...unit', '...device', '...object', and '...structure', and the like used below may mean at least one shape structure or may mean a unit processing a function.

In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' refers to at least one of elements from A (including A) to B (including B). Hereinafter, 'C' and/or 'D' means including at least one of 'C' or 'D', that is, {'C', 'D', and 'C' and 'D'}.

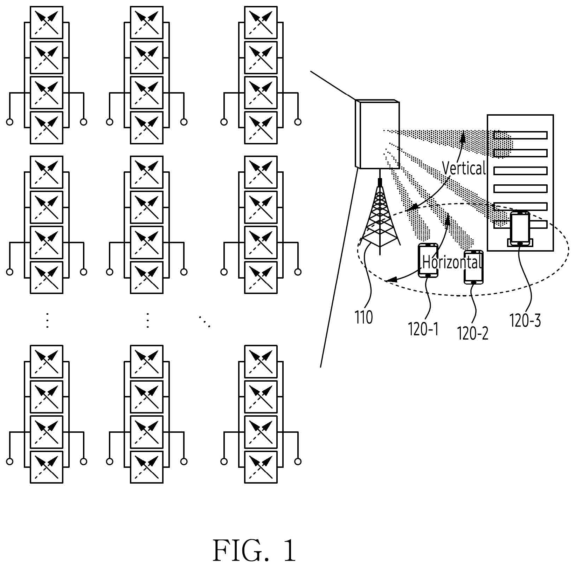

FIG. 1 illustrates an example of a wireless communication environment according to embodiments.

The wireless communication environment of FIG. 1 exemplifies, as a part of nodes using a wireless channel, a base station 110 and a terminal. Hereinafter, in the present disclosure, a common description of a terminal 120-1, a terminal 120-2, and a terminal 120-3 is performed through a terminal, for convenience of description.

Referring to FIG. 1, the base station 110 is a network infrastructure providing wireless access to a terminal. The base station 110 has a coverage based on a distance at which a signal may be transmitted. The base station 110 may be referred to as, in addition to a base station, an access point (AP), an eNB (eNodeB), a 5th generation node (5G node), a 5G NodeB (NB), a wireless point, a transmission/reception point (TRP), an access unit, a distributed unit (DU), a transmission/reception point (TRP), a radio unit (RU), a remote radio head (RRH), or another term having an equivalent technical meaning. The base station 110 may transmit a downlink signal or receive an uplink signal.

A terminal is a device used by a user and performs communication with a base station 110 through a wireless channel. In a case, the terminal may be operated without involvement of the user. That is, the terminal may be a device performing machine type communication (MTC) and may not be carried by the user. The terminal may be referred to as, in addition to a terminal, a user equipment (UE), a mobile station, a subscriber station' a customer premises equipment (CPE), a remote terminal, a wireless terminal, an electronic device, or a terminal for a vehicle, a user device, or another term having an equivalent technical meaning.

As one of techniques for mitigating a propagation path loss and increasing a transmission distance of radio waves, a beamforming technology is used. The beamforming generally concentrates a coverage area of radio waves by using a plurality of antennas, or increases directivity of a reception sensitivity for a specific direction. Accordingly, in order to form a beamforming coverage instead of forming a signal in an isotropic pattern by using a single antenna, the base station 110 may include a plurality of antennas. According to an embodiment, the base station 110 may include a Massive MIMO Unit (MMU). A form in which a plurality of antennas are aggregated may be referred to as an antenna array, each antenna included in the array may be referred to as an array element or an antenna element. The antenna array may be configured in various forms such as a linear array and a planar array. The antenna array may be referred to as a massive antenna array.

A major technology for improving a data capacity of 5G communication is a beamforming technology using an antenna array connected with a plurality of RF paths. For a higher data capacity, the number of RF paths or power per RF path should be increased. Increasing the RF path causes a size of a product to become larger, and due to a spatial constraint in installing actual base station equipment, it is currently at a level that cannot be further increased. In order to increase an antenna gain through a high output without increasing the number of RF paths, the antenna gain may be increased by connecting a plurality of antenna elements by using a divider or a splitter in an RF path. Herein, antenna elements corresponding to an RF path may be referred to as a sub array.

In order to increase communication performance, the number of antennas (or antenna elements) of equipment (e.g., the base station 110) performing wireless communication is increasing. In addition, the number of RF parts (e.g., an amplifier, a filter) for processing an RF signal received or transmitted through an antenna element and components also increases, and thus, in configuring communication equipment, a spatial gain and a cost efficiency are essentially required while satisfying communication performance.

In FIG. 1, although the base station 110 of FIG. 1 is described as an example to describe a connection assembly according to a structure for a signal line and a structure for a ground line of the present disclosure and an electronic device including the same, an embodiment of the present disclosure is not limited thereto. In addition to the base station 110, wireless equipment that performs the same function as the base station, wireless equipment (e.g., TRP) connected to the base station, the terminal of FIG. 1, or another communication equipment used for 5G communication are all possible as a matching network and an electronic device including the same.

Hereinafter, in the present disclosure, an antenna array configured with sub arrays is described as an example as a structure of a plurality of antennas for communication in a Multiple Input Multiple Output (MIMO) environment, but in some embodiments, an easy modification for beamforming is possible.

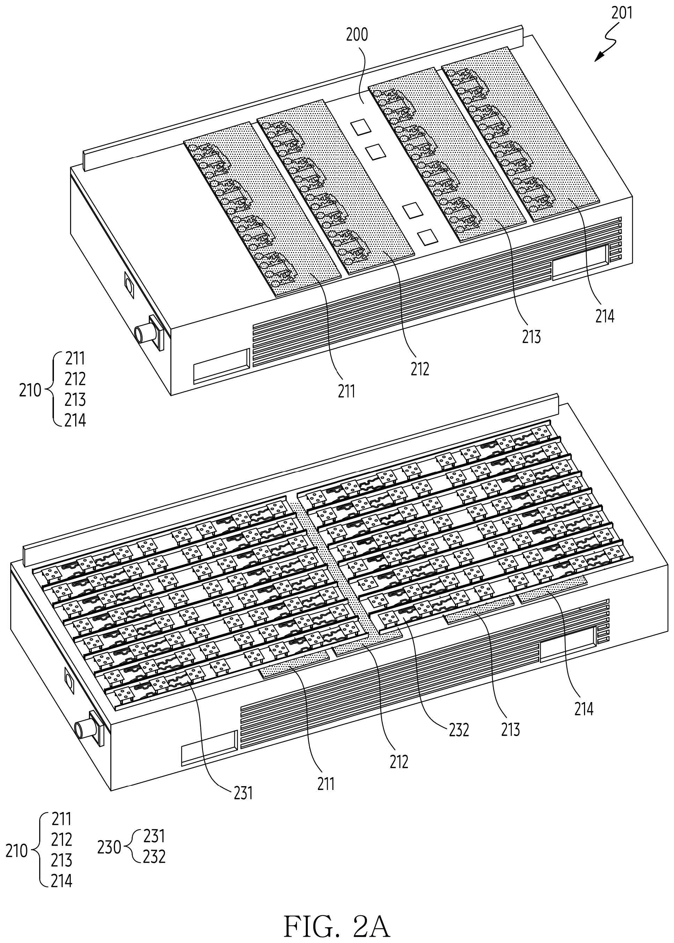

FIG. 2A illustrates an example of a stacked structure of an electronic device according to an embodiment.

Referring to FIG. 2A, equipment 201 refers to a radiation device of the base station 110. The equipment 201 may include a main board 200. A filter PCB 210 may be disposed on a surface of the main board 200. For example, a plurality of filter PCBs (e.g., a first filter PCB 211, a second filter PCB 212, a third filter PCB 213, and a fourth filter PCB 214) may be disposed on a surface of the main board 200. An antenna 230 may be disposed above the filter PCB 210. The equipment 201 may include a plurality of antennas. According to an embodiment, the equipment 201 may include an array antenna including a plurality of antenna elements. According to an embodiment, the equipment 201 may include an array antenna configured with a plurality of sub arrays. Each sub array may include a plurality of antenna elements. For example, each sub array may include four antenna elements. For example, the plurality of sub arrays may be disposed on a substrate for an antenna (hereinafter, an antenna substrate). For example, first sub arrays may be disposed on a first antenna substrate 231. Second sub arrays may be disposed on a second antenna substrate 232.

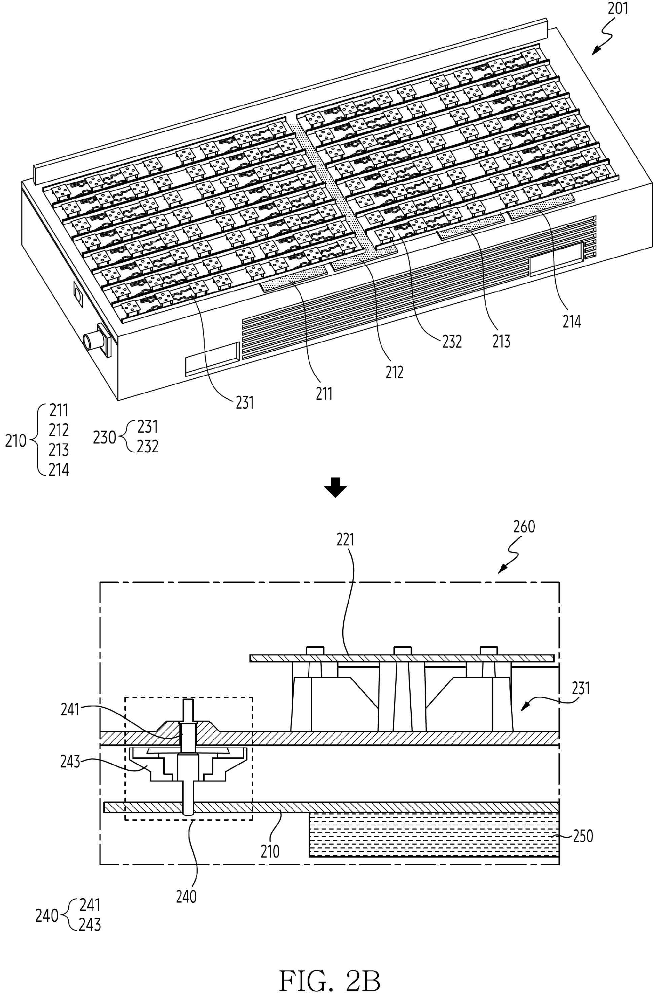

FIG. 2B illustrates an example of a connection structure of radio frequency (RF) components of an electronic device according to an embodiment.

Referring to FIG. 2B, an example of an antenna module 260 including a filter PCB 210, a first antenna substrate 231, and a connection structure 240 is illustrated. In the antenna module 260, a surface of the filter PCB 210 may be coupled to a surface of the first antenna substrate 231 through the connection structure 240. An antenna element 221 may be disposed on a portion of a surface opposite to the surface of the first antenna substrate 231. In FIG. 2B, an example in which one antenna element 221 is disposed on the portion of the first antenna substrate 231 is illustrated, but an embodiment of the present disclosure is not limited thereto. For example, a filter 250 may be disposed on a surface opposite to the surface of the filter PCB 210.

According to an embodiment, the connection structure 240 may include a signal pin 241 (or a signal line) and a ground line (or GND) to feed a signal to the antenna element 221. For example, the connection structure 240 may include the signal pin 241 used to feed the signal and the ground line surrounding the signal pin 241 and for shielding the signal pin 241. For example, the ground line may be included in a connector body 243 of the connection structure 240. In FIG. 2B, only one connection structure 240 is illustrated, but for a plurality of antennas, a plurality of connection structures 240 may be disposed between the first antenna substrate 231 and the filter PCB 210. In order to ensure a more stable connection, the number of contact points required between two RF components increases.

A tolerance refers to an allowable limit of a specification range. An allowable range determined based on a nominal size, that is, a specification range may be determined according to a tolerance. An accumulated tolerance or a tolerance accumulation amount may refer to an allowable limit of an assembly according to accumulation of an allowable limit of a single component in a case that a plurality of components are assembled. A processing tolerance may refer to a tolerance determined according to processing of a component. As communication equipment is implemented in a form in which a plurality of RF components are assembled, a tolerance generated at each assembly of RF components increases, which may cause degradation of performance. In addition, even in a case of performing a same function, a cost for satisfying required communication performance due to a structural difference and an electrical characteristic difference may also act as overhead.

In addition, in a case of the connection structure 240 including the connector body 243, a space required for a connection between the first antenna substrate 231 and the filter PCB 210 is required. For example, the connector body 243 may require a minimum size to surround the signal pin 241 and include the ground line. In addition, a space (or minimum space) for connecting a part of the connector body 243 to the filter PCB 210 through surface mount technology (SMT) may be required. In addition, in a case that one connection structure 240 includes a plurality of connector bodies, a relatively more space may be required.

In order to solve the above-described problems, in the present disclosure, an antenna module including a connector using an elastic member is proposed for a stable connection between RF components and securing a wider mounting space. In addition, when performing surface mounted technology (SMT), formation of an elastic member that is easy to move is required for efficient assembly between RF components (e.g., the filter PCB 210 or the first antenna substrate 231).

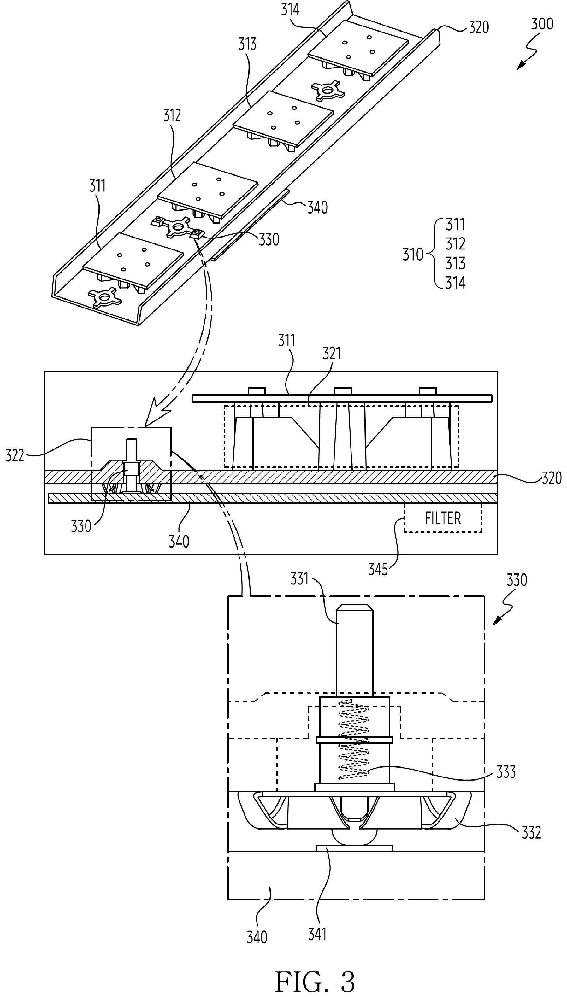

FIG. 3 illustrates an example of an antenna module including a connector using an elastic member according to an embodiment.

An antenna module 300 of FIG. 3 may be included in the base station 110 of FIG. 1. For example, the antenna module 300 may be included in the equipment 201 of FIG. 2A and FIG. 2B. For example, the equipment 201 may include a plurality of antenna modules 300. Hereinafter, in FIG. 3, an example of the antenna module 300 including antenna elements configuring a sub array is illustrated, but an embodiment of the present disclosure is not limited thereto.

Referring to FIG. 3, the antenna module 300 may include a plurality of antenna elements 310, an antenna substrate 320, a connector 330, and a filter PCB 340. For example, the antenna module 300 may include four antenna elements 310, an antenna substrate 320 on which four antenna elements 310 are disposed, a connector 330, and a filter PCB 340 connected to a filter (not illustrated). Hereinafter, the filter PCB 340 may be referred to as a PCB.

According to an embodiment, the antenna module 300 may include four antenna elements 310 configuring one sub array. For example, the antenna elements 310 may include a first antenna element 311, a second antenna element 312, a third antenna element 313, and a fourth antenna element 314. However, an embodiment of the present disclosure is not limited thereto. For example, the antenna elements 310 of the antenna module 300 may also include three or less or five or more antenna elements. The antenna elements 310 may be configured for an electronic device (e.g., the base station 110) including the antenna module 300 to transmit or receive a signal. For example, the electronic device may transmit or receive a signal (e.g., RF signal) through the antenna elements 310. For example, the antenna elements 310 may be referred to as a radiator or a main radiator.

According to an embodiment, each of antenna elements 310 may include a patch antenna. For example, each of the first antenna element 311, the second antenna element 312, the third antenna element 313, and the fourth antenna element 314 may be formed as a patch antenna. However, embodiments of the present disclosure are not limited thereto. For example, each of antenna elements 310 may include a dipole antenna, a dipole antenna, a folded dipole antenna, or a magneto-electric dipole antenna.

According to an embodiment, the antenna module 300 may further include an additional radiator other than the antenna elements 310. Although not illustrated in FIG. 3, the antenna module 300 may further include the additional radiator, respectively coupled with each of the antenna elements 310, receiving a signal radiated from the antenna elements 310, and re-radiating the signal. For example, the additional radiator may be used to improve a characteristic and a gain of the signal radiated through the antenna elements 310.

According to an embodiment, the plurality of antenna elements 310 may be disposed on the antenna substrate 320. For example, each of the antenna elements 310 may be disposed on the first area 321 of the antenna substrate 320. For example, the first area 321 may be formed to be thicker than the second area 322 of the antenna substrate 320. For example, a height from a surface of the antenna substrate 320 close to the filter PCB 340 to the antenna elements 310 disposed on the first area 321 may be higher than a height from the surface of the antenna substrate 320 to an end point of the second area 322. For example, the surface of the antenna substrate 320 may be referred to as a first surface of the antenna substrate 320. For example, the first surface of the antenna substrate 320 may be formed flat. For example, a second surface of the antenna substrate 320, opposite to the first surface of the antenna substrate 320, may be formed to have a plurality of heights.

According to an embodiment, the antenna substrate 320 may indicate a substrate on which the antenna elements 310 are disposed. For example, the antenna elements 310 may be disposed on the first area 321 of the antenna substrate 320. For example, as holes (or recesses) of each of the antenna elements 310 are coupled with some protrusions of the first area 321 of the antenna substrate 320, each of the antenna elements 310 may be disposed on the first area 321.

According to an embodiment, the antenna substrate 320 may be formed of a dielectric. For example, the antenna substrate 320 may be implemented through injection of the dielectric. For example, a connector 330 may be disposed in the second area 322 of the antenna substrate 320. For example, the connector 330 may penetrate the second area 322, which is a partial area of the antenna substrate 320 configured with the dielectric. For example, the connector 330 may be configured in the second area 322 of the antenna substrate 320, through injection or press fit.

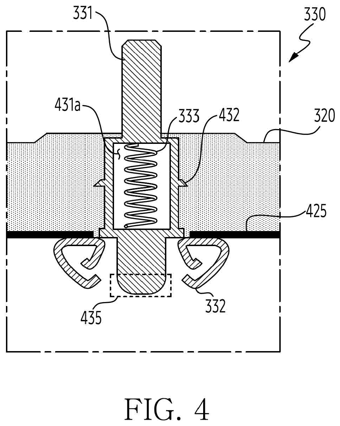

According to an embodiment, the connector 330 may include a conductive portion 331 and an elastic portion 332. For example, the connector 330 may include the conductive portion 331 for transmitting, to the antenna elements 310, a signal transmitted through the filter PCB 340. For example, the conductive portion 331 may be formed of a conductive member for transmitting the signal. In addition, the conductive portion 331 of the connector 330 may be surrounded by the elastic portion 332. For example, the elastic portion 332 may be disposed on the first surface of the antenna substrate 320 with respect to the conductive portion 331. For example, the elastic portion 332 may be attached on the first surface of the antenna substrate 320 through an adhesive, or may be configured in the second area 322 of the antenna substrate 320 through injection or press fit. For example, the elastic portion 332 may be used to provide a ground with respect to the conductive portion 331 for transmitting the signal. For example, the ground may be provided through a conductive surface included in the antenna substrate 320 connected with the elastic portion 332. A specific content related thereto is described in FIG. 4 below.

According to an embodiment, the connector 330 may further include an elastic member 333. For example, the elastic member 333 of the connector 330 may be disposed or formed in the conductive portion 331. For example, the conductive portion 331 may include the elastic member 333.

According to an embodiment, the connector 330 may be used to connect the antenna substrate 320 and the filter PCB 340. For example, the connector 330 may be contacted with the second area 322 of the antenna substrate 320 and a surface of the filter PCB 340, in a state located in the second area 322 of the antenna substrate 320. For example, in the the filter PCB 340, a filter 345 may be disposed on a first surface of the filter PCB 340. For example, the connector 330 may be contacted with a second surface opposite to the first surface of the filter PCB 340. For example, the connector 330 may be contacted with a conductive portion 341 of the second surface of the filter PCB 340. For example, the conductive portion 341 may be a port for transmitting a signal to the antenna elements 310 through the connector 330.

According to an embodiment, when the connector 330 is contacted with the second surface of the filter PCB 340, the elastic portion 332 and the elastic member 333 of the connector 330 may be compressed. For example, as a pressure between the connector 330 and the filter PCB 340 increases (or as a distance between the connector 330 and the filter PCB 340 becomes closer), the elastic portion 332 and the elastic member 333 of the connector 330 may be compressed.

According to an embodiment, the filter PCB 340 may indicate a PCB to which the filter 345 is connected. For example, the filter PCB 340 may include the filter 345 for performing filtering on a signal provided to each of the antenna elements 310. For example, the filter 345 may be disposed on the first surface of the filter PCB 340. For example, the conductive portion 341 of the filter PCB 340 may be disposed on a second surface opposite to the first surface of the filter PCB 340. For example, the conductive portion 341 may indicate a port for being connected with the conductive portion 331 of the connector 330.

Although not illustrated in FIG. 3, according to an embodiment, the antenna module 300 may further include another connector (not illustrated). For example, the antenna module 300 may include a plurality of connectors. The description of the connector 330 may be substantially identically applied to a description of the another connector. For example, the another connector may be disposed in a third area different from the first area and the second area of the antenna substrate 320.

According to an embodiment, the plurality of connectors of the antenna module 300 may be used to provide, to the antenna elements 310 of the antenna module 300, signals having different polarizations. For example, the connector 330 may be used to provide, to the antenna elements 310, a signal having a first polarization. For example, the another connector may be used to provide, to the antenna elements 310, a signal having a second polarization different from the first polarization. For example, in a case that the first polarization is a vertical polarization, the second polarization may be a horizontal polarization. For example, in a case that the first polarization is a clockwise circular polarization, the second polarization may be a counterclockwise circular polarization.

Although not illustrated in FIG. 3, according to an embodiment, the antenna module 300 may further include a signal line. For example, the antenna module 300 may further include the signal line for connecting each of the antenna elements 310 and the connector 330. For example, the signal line may be disposed on the antenna substrate 320. For example, the signal line may be disposed on the second surface of the antenna substrate 320. For example, the signal line may be used to provide, from the connector 330 to each antenna element, a signal for the antenna module 300 to radiate. According to an embodiment, the another connector and each of the antenna elements 310 may be connected through another signal line. For example, the another signal line may be disposed on the second surface of the antenna substrate 320.

Although not illustrated in FIG. 3, according to an embodiment, a circuit (e.g., a radio frequency integrated circuit (RFIC)) for providing the signal may be disposed on the first surface of the filter PCB 340 included in the antenna module 300. For example, the circuit may be disposed in an area different from an area in which the filter 345 of the first surface of the filter PCB 340 is disposed. Alternatively, according to an embodiment, the antenna module 300 may further include an additional PCB different from the filter PCB 340. For example, the additional PCB may be disposed below the filter PCB 340 of the antenna module 300. For example, the circuit may be disposed on the additional PCB. According to an embodiment, for a connection between the additional PCB and the filter PCB 340, the connector 330 may also be used. For example, the antenna module 300 may include the connector 330 (or a plurality of connectors (e.g., the connector 330 and the another connector)) connecting the antenna substrate 320 and the filter PCB 340 and the connector 330 connecting the filter PCB 340 and the additional PCB.

Referring to the above description, according to embodiments of the present disclosure, the antenna module 300 including the connector 330 of the antenna substrate 320 formed of a dielectric and an electronic device (e.g., the base station 110 or an MMU of the base station 110) including the same may electrically connect the filter PCB 340 and the antenna elements 310 without a separate component (e.g., the connector body 243 of FIG. 2B) for connecting with the filter PCB 340 for a signal pin (e.g., the signal pin 241 of FIG. 2B) transmitting the signal. Since the antenna module and the electronic device according to embodiments of the present disclosure do not include the separate component, an SMT process for assembling the separate component on the filter PCB 340 may not be required. Since the antenna module and the electronic device according to embodiments of the present disclosure do not require the separate component, a space for installation may be reduced and a design change of the antenna module may be easy. Since the antenna module and the electronic device according to embodiments of the present disclosure do not require the separate component, a production cost may be reduced.

FIG. 4 illustrates an example of a connector using an elastic member according to an embodiment.

A connector 330 of FIG. 4 may indicate an example of the connector 330 of FIG. 3. The connector 330 of FIG. 4 may indicate an example of a cross-sectional view of the connector 330 of FIG. 3. For example, each of a conductive portion 331, an elastic portion 332, and an elastic member 333 of the connector 330 of FIG. 4 may correspond to the conductive portion 331, the elastic portion 332, and the elastic member 333 of the connector 330 of FIG. 3. The same reference numerals may be referred to for the same description.

Referring to FIG. 4, the connector 330 may include a conductive portion 331, an elastic portion 332, and an elastic member 333. For example, the connector 330 may be included in an antenna substrate 320 of an antenna module (e.g., the antenna module 300 of FIG. 3). For example, the connector 330 may be configured in an area (e.g., the second area 322 of FIG. 3) of the antenna substrate 320 through injection or press fit.

According to an embodiment, the connector 330 may include a conductive portion 331 for transmitting a signal. For example, the connector 330 may include a conductive portion 331 for obtaining the signal provided through a conductive portion (e.g., the conductive portion 341 of FIG. 3) of a filter PCB (e.g., the filter PCB 340 of FIG. 3) contacted with a contact portion 435 of the connector 330 and transmitting the signal to antenna elements (e.g., the antenna elements 310 of FIG. 3). For example, the elastic member 333 may be included in the conductive portion 331. For example, the elastic member 333 may be disposed in a space 431a in the conductive portion 331. For example, in a case that the connector 330 and the filter PCB 340 are contacted, the elastic member 333 may be used to maintain the contact. In addition, since the contact is maintained by using an elastic force of the elastic member 333, a flexible design and connection may be possible with respect to a tolerance (or an assembly tolerance).

Referring to FIG. 4, although an example in which a shape of the contact portion 435 at which the connector 330 and the filter PCB 340 are contacted is formed as a semicircle (or a hemisphere) is illustrated, an embodiment of the present disclosure is not limited thereto. For example, the shape of the contact portion 435 may be variously implemented. For example, the shape may be implemented as a pointed pin shape, an inverted T shape, and the like.

According to an embodiment, the conductive portion 331 of the connector 330 may be configured integrally with the antenna substrate 320, through insert injection during injection molding of the antenna substrate 320. For example, during injection molding of the antenna substrate 320, the conductive portion 331 may be configured integrally with the antenna substrate 320, by performing insert injection in a state in which the conductive portion 331 of the connector 330 is disposed at a position corresponding to the second area 322 of the antenna substrate 320.

In addition, according to an embodiment, the conductive portion 331 of the connector 330 may be coupled with the antenna substrate 320 through press fit (or forcing in) after injection molding of the antenna substrate 320. For example, after injection of the antenna substrate 320, the conductive portion 331 may be disposed in the second area 322 of the antenna substrate 320 by press-fitting the conductive portion 331 with respect to the second area 322 of the antenna substrate 320. For example, a protrusion 432 of the conductive portion 331 may be inserted into a groove of the antenna substrate 320 according to the press fit.

According to an embodiment, the connector 330 may include an elastic portion 332. For example, the connector 330 may include the elastic portion 332 surrounding the conductive portion 331 for transmitting the signal. For example, the elastic portion 332 may shield the conductive portion 331 to increase transmission performance of the signal provided through the conductive portion 331. For example, the elastic portion 332 may operate as a ground (GND) for the shielding. For example, the elastic portion 332 may be connected with a conductive surface 425 included in an antenna substrate 320. For example, the elastic portion 332 may be electrically connected with the conductive surface 425. For example, the conductive surface 425 may be connected with a ground of the antenna module 300. Accordingly, the elastic portion 332 may be electrically connected with the ground of the antenna module 300 by being connected with the conductive surface 425. The elastic portion 332 electrically connected with the ground of the antenna module 300 may electrically shield the conductive portion 331.

According to an embodiment, the elastic portion 332 of the connector 330 may be configured with a conductive member (or an elastic member) having an elastic force. For example, the elastic portion 332 may be attached through an adhesive on a surface (e.g., the first surface of the antenna substrate 320) of the antenna substrate 320, or may be configured through press fit or injection.

According to an embodiment, the antenna substrate 320 of the connector 330 may be formed through injection molding. For example, at least a portion of dielectric of the antenna substrate 320 may be included in the connector 330. For example, the at least a portion may surround the conductive portion 331 operating as a signal line of the connector 330. For example, a size (or a thickness) of the at least a portion may be determined based on at least one of a frequency band of the signal transmitted through the conductive portion 331 or a dielectric constant of the at least a portion.

According to an embodiment, the conductive surface 425 of the antenna substrate 320 may be configured through a plating process after injection of the antenna substrate 320. For example, the conductive surface 425 may be formed through the plating process after the antenna substrate 320 formed of a dielectric is injected. In addition, according to an embodiment, the conductive portion 331 of the connector 330 may also be configured through a plating process after injection of the antenna substrate 320.

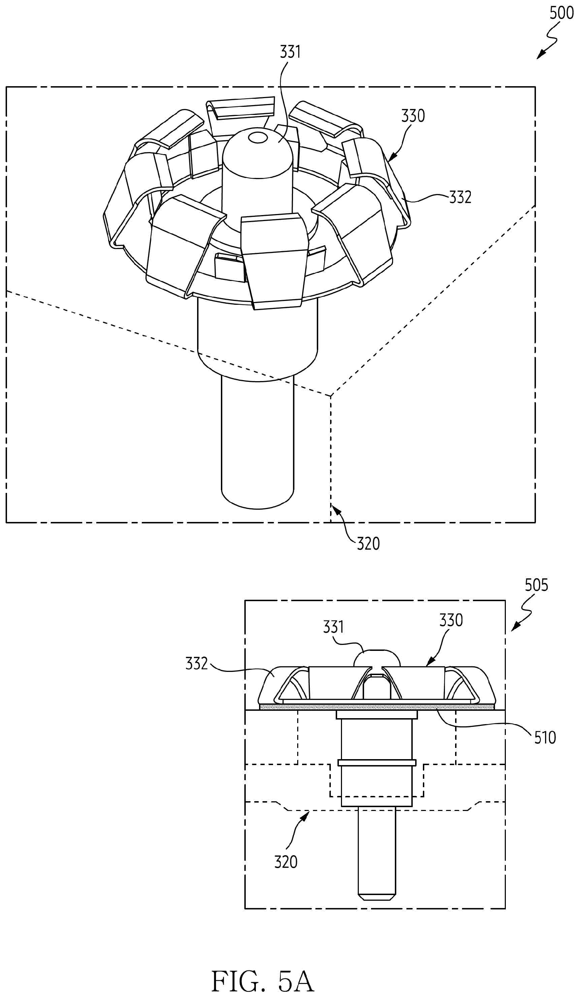

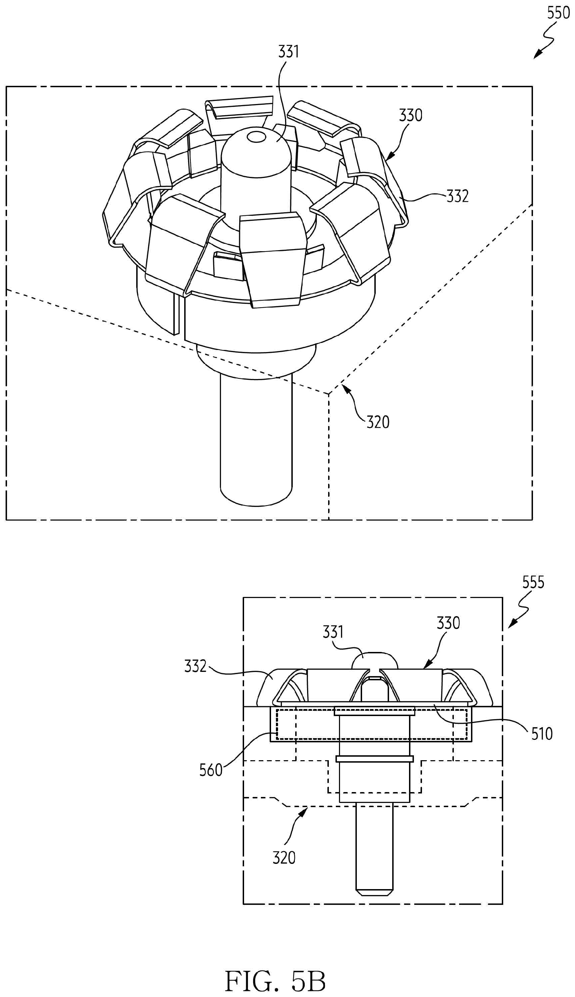

FIG. 5A and FIG. 5B illustrate examples of a connection between a connector using an elastic member and an antenna substrate according to an embodiment.

A connector 330 of FIG. 5A and FIG. 5B may indicate an example of the connector 330 of FIG. 3. An antenna substrate 320 of FIG. 5A and FIG. 5B may indicate an example of the antenna substrate 320 of FIG. 3. The same reference numerals may be referred to for the same description.

Referring to FIG. 5A and FIG. 5B, the connector 330 may include a conductive portion 331, an elastic portion 332, and an elastic member 333. For example, the connector 330 may be included in an antenna substrate 320 of an antenna module (e.g., the antenna module 300 of FIG. 3). For example, the connector 330 may be configured in an area (e.g., the second area 322 of FIG. 3) of the antenna substrate 320 through injection or press fit.

Referring to FIG. 5A, examples 500 and 505 in which the connector 330 is configured through injection in the area of the antenna substrate 320 are illustrated. Referring to the example 500, the conductive portion 331 of the connector 330 may be surrounded by the elastic portion 332. For example, the elastic portion 332 may surround the conductive portion 331 in a state spaced apart from the conductive portion 331. Referring to the example 500, the elastic portion 332 may include a plurality of parts. For example, each of the plurality of parts of the elastic portion 332 may be formed of a metal having an elastic force. Referring to the example 505, the elastic portion 332 may be attached on a surface of the antenna substrate 320 (e.g., a first surface of the antenna substrate 320), through an adhesive 510. For example, the elastic portion 332 may be coupled with the antenna substrate 320 by the adhesive 510.

Referring to FIG. 5B, examples 550 and 555 in which the connector 330 is configured through press fit in the area of the antenna substrate 320 are illustrated. Referring to the example 550, the conductive portion 331 of the connector 330 may be surrounded by the elastic portion 332. For example, the elastic portion 332 may surround the conductive portion 331 in a state spaced apart from the conductive portion 331. The elastic portion 332 may include a plurality of parts. For example, each of the plurality of parts of the elastic portion 332 may be formed of a metal having an elastic force. Referring to the example 555, the elastic portion 332 may be fitted into a surface of the antenna substrate 320 (e.g., the first surface of the antenna substrate 320). For example, the elastic portion 332 may be fitted into an area 560 of the surface of the antenna substrate 320 by an external force. For example, a portion of the elastic portion 332 contacting the area 560 is inserted by the external force, and an elastic force of the portion of the elastic portion 332 acts toward the area 560, and thus the elastic portion 332 may be coupled with the area 560 of the antenna substrate 320.

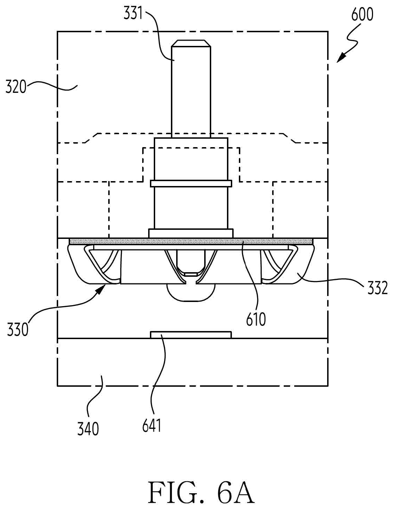

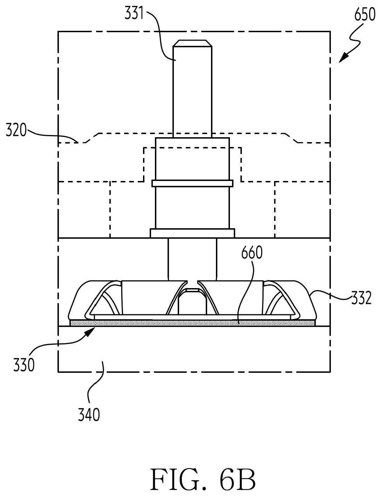

FIG. 6A and FIG. 6B illustrate examples of a connection between a connector using an elastic member and a printed circuit board (PCB) on which a filter is disposed, according to an embodiment.

A connector 330 of FIG. 6A and FIG. 6B may indicate an example of the connector 330 of FIG. 3. An antenna substrate 320 of FIG. 6A and FIG. 6B may indicate an example of the antenna substrate 320 of FIG. 3. The same reference numerals may be referred to for the same description.

Referring to FIG. 6A and FIG. 6B, the connector 330 may include a conductive portion 331, an elastic portion 332, and an elastic member 333. For example, the connector 330 may be included in an antenna substrate 320 of an antenna module (e.g., the antenna module 300 of FIG. 3). For example, the connector 330 may be configured in an area (e.g., the second area 322 of FIG. 3) of the antenna substrate 320 through injection or press fit.

FIG. 6A illustrates an example 600 of a method for connecting the antenna substrate 320 and a filter PCB 340 by using the connector 330 included in the antenna substrate 320. In the example 600 of FIG. 6A, the antenna module 300 in which the elastic portion 332 of the connector 330 is connected with the antenna substrate 320 through an adhesive 610 is exemplified, but an embodiment of the present disclosure is not limited thereto.

Referring to the example 600, in a state in which the antenna substrate 320 of the antenna module 300 and the filter PCB 340 are not connected (or in a spaced state), the connector 330 of the antenna module 300 may be spaced apart from the filter PCB 340. For example, the conductive portion 331 of the connector 330 may be spaced apart from a conductive portion 641 of the filter PCB 340. For example, the conductive portion 641 may be an example of the conductive portion 341 of FIG. 3. At this time, the conductive portion 331 of the connector 330 may be aligned with the conductive portion 641 of the filter PCB 340. For example, in a state in which the antenna substrate 320 of the antenna module 300 and the filter PCB 340 are connected (or in a connected state), the connector 330 of the antenna module 300 may be contacted with the filter PCB 340. For example, the conductive portion 331 of the connector 330 may be contacted with the conductive portion 641 of the filter PCB 340. At this time, the conductive portion 331 of the connector 330 may be configured to transmit, to an antenna element (e.g., the antenna elements 310 of FIG. 3), a signal provided through the conductive portion 641 of the filter PCB 340.

FIG. 6B illustrates an example 650 of a method for connecting the antenna substrate 320 and the filter PCB 340 by using the connector 330 included in the antenna substrate 320. In the example 650 of FIG. 6B, the antenna module 300 in which the elastic portion 332 of the connector 330 is connected with the filter PCB 340 through an adhesive 660 is exemplified, but an embodiment of the present disclosure is not limited thereto. For example, the elastic portion 332 may be attached on a second surface of the filter PCB 340 through the adhesive 660.

Referring to the example 650, in a state in which the antenna substrate 320 of the antenna module 300 and the filter PCB 340 are not connected (or in a spaced state), the connector 330 of the antenna module 300 may be spaced apart from the filter PCB 340. For example, the conductive portion 331 of the connector 330 may be spaced apart from a conductive portion (not illustrated) of the filter PCB 340. For example, the conductive portion of the filter PCB 340 may be located at a center of the elastic portion 332 disposed on the second surface of the filter PCB 340. At this time, the conductive portion 331 of the connector 330 may be aligned with the conductive portion of the filter PCB 340. For example, in a state in which the antenna substrate 320 of the antenna module 300 and the filter PCB 340 are connected (or in a connected state), the connector 330 of the antenna module 300 may be contacted with the filter PCB 340. For example, the conductive portion 331 of the connector 330 may be contacted with the conductive portion of the filter PCB 340. In a case that the conductive portion 331 of the connector 330 is contacted with the conductive portion of the filter PCB 340, at least a portion of a first surface of the antenna substrate 320 may be contacted with the elastic portion 332. For example, at least a portion of the first surface of the antenna substrate 320 may indicate the first surface surrounding the conductive portion 331 of the connector 330. At this time, the conductive portion 331 of the connector 330 may be configured to transmit, to an antenna element (e.g., the antenna elements 310 of FIG. 3), a signal provided through the conductive portion of the filter PCB 340.

In FIG. 6A and FIG. 6B, although examples 600 and 650 in which the elastic portion 332 of the connector 330 is attached to a surface of the antenna substrate 320 or the filter PCB 340 by using the adhesive 610 or 660 are illustrated, an embodiment of the present disclosure is not limited thereto. For example, embodiments of the present disclosure may also be applied to the antenna module 300 including the connector 330 fitted into a partial area (e.g., the area 560 of FIG. 5B) of the antenna substrate 320 or a partial area of the filter PCB 340, as in the example 550 illustrated in FIG. 5B.

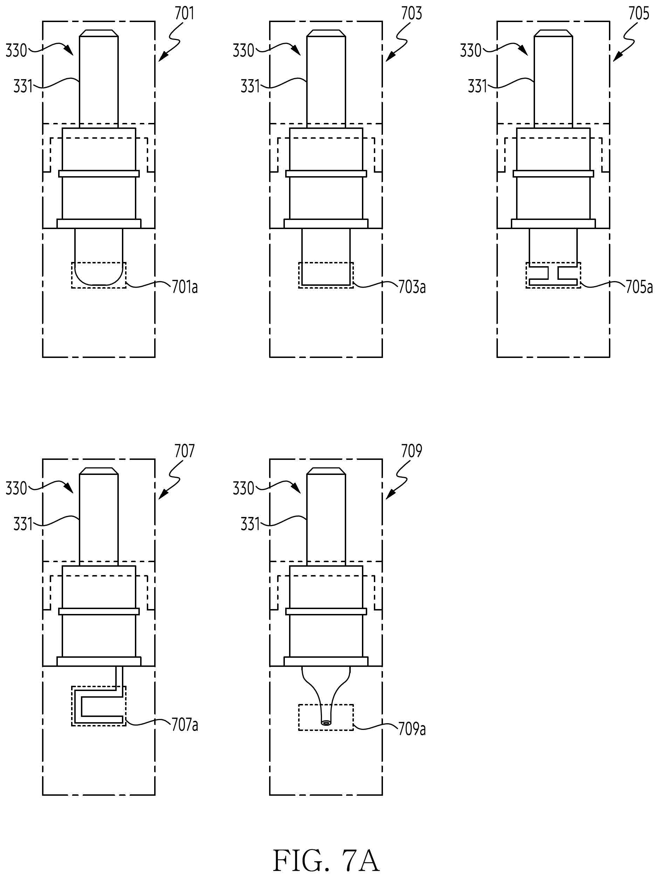

FIG. 7A illustrates examples of a conductive portion of a connector according to an embodiment.

A connector 330 of FIG. 7A may indicate an example of the connector 330 of FIG. 3. The same reference numerals may be referred to for the same description.

FIG. 7A illustrates examples 701, 703, 705, 707, and 709 of various shapes of a conductive portion 331 of the connector 330. The various shapes of the conductive portion 331 of FIG. 7A are merely exemplary, and an embodiment of the present disclosure is not limited thereto.

Referring to the example 701 of FIG. 7A, a contact portion 701a of the conductive portion 331 of the connector 330 may have a shape convex with respect to an outside of the conductive portion 331. The contact portion 701a of the example 701 may have a hemispherical shape having a designated curvature. For example, the contact portion 701a having a convex shape may be easily contacted (or coupled) with a conductive portion (e.g., the conductive portion 341 of the filter PCB 340 of FIG. 3) of a filter PCB (e.g., the filter PCB 340 of FIG. 3) having a concave shape. For example, when the contact portion 701a is coupled with the conductive portion of the filter PCB having a concave shape to correspond to a shape of the contact portion 701a, a fastening force may increase. However, an embodiment of the present disclosure is not limited thereto. For example, the conductive portion of the filter PCB may have a flat shape.

Referring to the example 703 of FIG. 7A, a contact portion 703a of the conductive portion 331 of the connector 330 may have a flat shape. The contact portion 703a of the example 703 may be substantially parallel to a first surface of an antenna substrate (e.g., the antenna substrate 320 of FIG. 3) in which the connector 330 is disposed (or coupled). For example, the contact portion 703a having a flat shape may be easy to design and produce the contact portion 703a, and may be contacted (or coupled) with a conductive portion (e.g., the conductive portion 341 of the filter PCB 340 of FIG. 3) of various shapes of filter PCBs (e.g., the filter PCB 340 of FIG. 3).

Referring to the example 705 of FIG. 7A, a contact portion 705a of the conductive portion 331 of the connector 330 may have an inverted T shape. The contact portion 705a of the example 705 may extend from a central axis of the conductive portion 331 of the connector 330. For example, the contact portion 705a having the inverted T shape may have a wide contact area for contacting a conductive portion (e.g., the conductive portion 341 of the filter PCB 340 of FIG. 3) of a filter PCB (e.g., the filter PCB 340 of FIG. 3). Accordingly, the contact portion 705a may be easily contacted with the conductive portion of the filter PCB. At this time, the contact portion 705a with a lighter structure than the contact portion 703a may reduce a weight of an antenna module (e.g., the antenna module 300 of FIG. 3) or an electronic device (e.g., the base station 110 of FIG. 1) including the connector 330.

Referring to the example 707 of FIG. 7A, a contact portion 707a of the conductive portion 331 of the connector 330 may have a '⊏' shape. The contact portion 707a of the example 707 may extend from the conductive portion 331 of the connector 330. The contact portion 707a of the example 707 may be formed of a metal having an elastic force. In a case of using the contact portion 707a having the elastic force, a contact state between the conductive portion 331 of the connector 330 and a conductive portion (e.g., the conductive portion 341 of the filter PCB 340 of FIG. 3) of a filter PCB (e.g., the filter PCB 340 of FIG. 3) may be easily maintained.

Referring to the example 709 of FIG. 7A, a contact portion 709a of the conductive portion 331 of the connector 330 may have a concave shape. For example, the contact portion 709a may have a column shape having a wide area as being closer to an antenna substrate (e.g., the antenna substrate 320 of FIG. 3) to which the connector 330 is coupled and having a narrow area as being farther from the antenna substrate. For example, the contact portion 709a may be easily contacted (or coupled) with a conductive portion (e.g., the conductive portion 341 of the filter PCB 340 of FIG. 3) of a filter PCB (e.g., the filter PCB 340 of FIG. 3) having a hole (or a recess). For example, when the contact portion 709a is coupled with the conductive portion of the filter PCB having the hole to correspond to a shape of the contact portion 709a, a fastening force may increase. However, an embodiment of the present disclosure is not limited thereto. For example, the conductive portion of the filter PCB may have a flat shape.

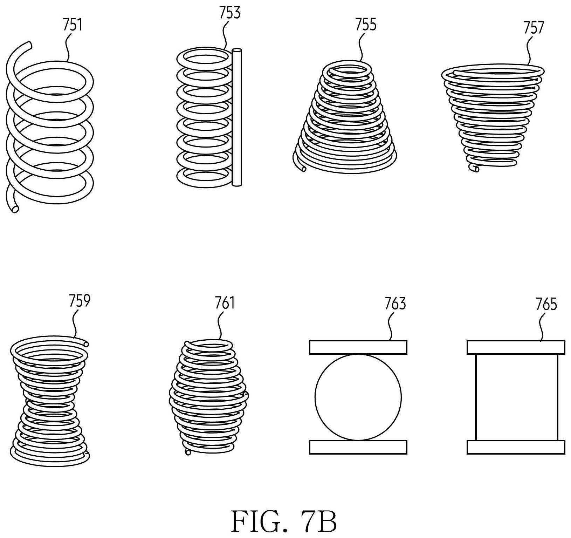

FIG. 7B illustrates examples of an elastic member of a connector according to an embodiment.

Elastic members 751, 753, 755, 757, 759, 761, 763, and 765 of FIG. 7B may indicate an example of the elastic member 333 of the connector 330 of FIG. 3. FIG. 7B illustrates examples of various shapes of the elastic member 333 of the connector 330. The elastic members 751, 753, 755, 757, 759, 761, 763, and 765 of FIG. 7B are merely exemplary, and an embodiment of the present disclosure is not limited thereto.

According to an embodiment, the connector 330 including one elastic member among the elastic members 751, 753, 755, 757, 759, 761, 763, and 765 illustrated in FIG. 7B may be included in the antenna module 300. For example, the connector 330 may include, within the conductive portion 331 of the connector 330, one elastic member among the elastic members 751, 753, 755, 757, 759, 761, 763, and 765 illustrated in FIG. 7B.

Referring to FIG. 7B, the elastic member 751 may be a spring in which an area of an upper portion and an area of a lower portion are identical. Like the elastic member 751, the elastic member 753 may be a spring in which an area of an upper portion and an area of a lower portion are identical. However, the elastic member 753 may further include, with respect to the elastic member 751, a straight support portion extending from the upper portion to the lower portion.

Referring to FIG. 7B, the elastic member 755 and the elastic member 757 may be springs in which an area of an upper portion and an area of a lower portion are different. For example, the elastic member 755 may be a spring in which an upper portion has a relatively narrow area with respect to a lower portion. In contrast, the elastic member 757 may be a spring in which an upper portion has a relatively wide area with respect to a lower portion.

Referring to FIG. 7B, the elastic member 759 and the elastic member 761 may be springs in which an area of an upper portion and an area of a lower portion are identical, but an area of a portion between the upper portion and the lower portion (hereinafter, a middle portion) is different from the upper portion and the lower portion. For example, the elastic member 759 may be a spring in which an area of an upper portion and an area of a lower portion of the elastic member 759 are relatively wider than an area of a middle portion. In contrast, the elastic member 759 may be a spring in which an area of an upper portion and an area of a lower portion of the elastic member 759 are relatively narrower than an area of a middle portion.

Referring to FIG. 7B, the elastic member 763 and the elastic member 765 may include a plate (or surface)-type elastic body. For example, the elastic member 763 may include plate-type elastic bodies, and may include a circular member (e.g., rubber, metal) having an elastic force between the plate-type elastic bodies. In addition, for example, the elastic member 765 may include plate-type elastic bodies, and may include a rectangular member (e.g., rubber, metal) having an elastic force between the plate-type elastic bodies. The plate-type elastic bodies of the elastic member 763 or the elastic member 765 may be formed of a metal (or a conductive member). At this time, the plate-type elastic bodies may be electrically coupled with each other.

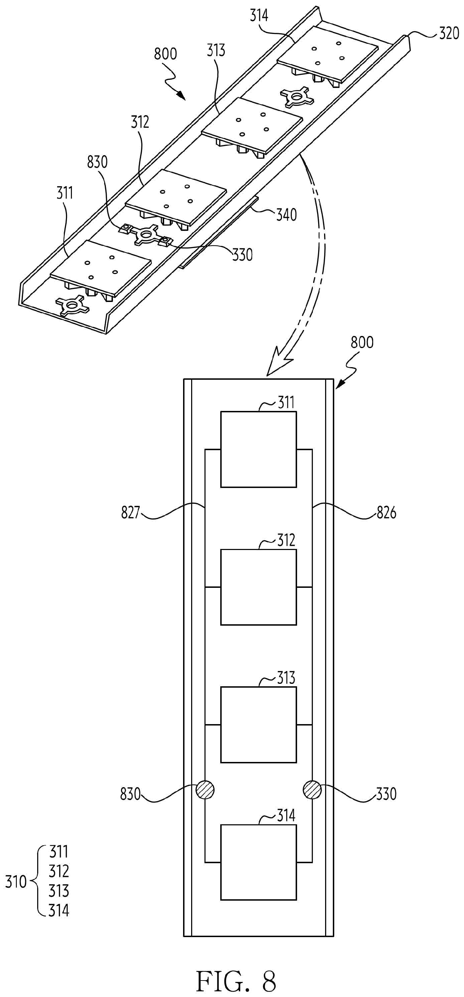

FIG. 8 illustrates an example of an antenna module including a plurality of connectors according to an embodiment.

An antenna module 800 of FIG. 8 may be included in the base station 110 of FIG. 1. The antenna module 800 of FIG. 8 may indicate an example of the antenna module 300 of FIG. 3. For example, the antenna module 800 may be included in the equipment 201 of FIG. 2A and FIG. 2B. For example, the equipment 201 may include a plurality of antenna modules 800. Hereinafter, an example of the antenna module 800 including antenna elements configuring one sub array is illustrated in FIG. 8, but an embodiment of the present disclosure is not limited thereto.

Referring to FIG. 8, an antenna module 800 may include a plurality of antenna elements 310, an antenna substrate 320, a connector 330, a connector 830, and a filter PCB 340. For example, the antenna module 300 may include four antenna elements 310, the antenna substrate 320 on which four antenna elements 310 are disposed, the connector 330, the connector 830, and the filter PCB 340 connected to a filter (not illustrated).

According to an embodiment, the antenna module 800 may include four antenna elements 310 configuring one sub array. For example, the antenna elements 310 may include a first antenna element 311, a second antenna element 312, a third antenna element 313, and a fourth antenna element 314. However, an embodiment of the present disclosure is not limited thereto. For example, the antenna elements 310 of the antenna module 300 may include three or less or five or more antenna elements. The antenna elements 310 may be configured for an electronic device including the antenna module 800 (e.g., the base station 110) to transmit or receive a signal. For example, the electronic device may transmit or receive a signal (e.g., an RF signal) through the antenna elements 310. For example, the antenna elements 310 may be referred to as a radiator or a main radiator.

According to an embodiment, each of antenna elements 310 may include a patch antenna. For example, each of the first antenna element 311, the second antenna element 312, the third antenna element 313, and the fourth antenna element 314 may be formed as a patch antenna. However, embodiments of the present disclosure are not limited thereto. For example, each of antenna elements 310 may include a dipole antenna, a dipole antenna, a folded dipole antenna, or a magneto-electric (ME) dipole antenna.

According to an embodiment, the antenna module 300 may further include an additional radiator other than antenna elements 310. Although not illustrated in FIG. 3, the antenna module 300 may further include the additional radiator, coupled with each of antenna elements 310, receiving a signal radiated from antenna elements 310, and re-radiating the signal. For example, the additional radiator may be used to improve a characteristic and a gain of the signal radiated through antenna elements 310.

According to an embodiment, the antenna elements 310 may be disposed on an antenna substrate 320. For example, each of the antenna elements 310 may be disposed on a first area (e.g., the first area 321 of FIG. 3) of the antenna substrate 320. For example, the first area 321 may be formed to be thicker than a second area (e.g., the second area 322 of FIG. 3) of the antenna substrate 320. For example, a height from a surface of the antenna substrate 320 close to the filter PCB 340 to the antenna elements 310 disposed on the first area may be higher than a height from the surface of the antenna substrate 320 to an end point of the second area. For example, the surface of the antenna substrate 320 may be referred to as a first surface of the antenna substrate 320. For example, the first surface of the antenna substrate 320 may be formed flat. For example, a second surface of the antenna substrate 320, opposite to the first surface of the antenna substrate 320, may be formed to have a plurality of heights.

According to an embodiment, the antenna substrate 320 may indicate a substrate on which antenna elements 310 are disposed. For example, the antenna elements 310 may be disposed on the first area 321 of the antenna substrate 320. For example, each of the antenna elements 310 may be disposed on the first area 321 as holes (or recesses) of each of the antenna elements 310 and some protrusions of the first area 321 of the antenna substrate 320 are coupled.

According to an embodiment, the antenna substrate 320 may be formed of a dielectric. For example, the antenna substrate 320 may be implemented through injection of the dielectric. For example, a connector 330 or a connector 830 may be disposed in the second area of the antenna substrate 320. For example, each of the connector 330 and the connector 830 may penetrate the second area and a third area, which are partial areas of the antenna substrate 320 configured with the dielectric. For example, the connector 330 may be configured in the second area of the antenna substrate 320 through injection or press fit. For example, the connector 830 may be configured in the third area of the antenna substrate 320 through injection or press fit. For example, the third area may indicate a position on the antenna substrate 320 opposite to the second area with respect to the antenna elements 310.

According to an embodiment, the connector 330 may include a conductive portion (e.g., the conductive portion 331 of FIG. 3) and an elastic portion (e.g., the elastic portion 332 of FIG. 3). For example, the connector 330 may include the conductive portion for transmitting, to the antenna elements 310, a signal transmitted through the filter PCB 340. For example, the conductive portion may be formed of a conductive member for transmitting the signal. In addition, the conductive portion of the connector 330 may be surrounded by the elastic portion. For example, the elastic portion may be disposed on the first surface of the antenna substrate 320 around the conductive portion. For example, the elastic portion may be attached to the first surface of the antenna substrate 320 through an adhesive, or may also be configured in the second area of the antenna substrate 320 through injection or press fit. For example, the elastic portion may be used to provide a ground to the conductive portion for transmitting the signal. For example, the ground may be provided through a conductive surface included in the antenna substrate 320 connected with the elastic portion.

According to an embodiment, the connector 330 may further include an elastic member (e.g., the elastic member 333 of FIG. 3). For example, the elastic member of the connector 330 may be disposed (or formed) in the conductive portion. For example, the conductive portion 331 may include the elastic member.

According to an embodiment, the connector 830 may include a conductive portion, an elastic portion, and an elastic member. The description of each of the conductive portion, the elastic portion, and the elastic member included in the connector 330 may be substantially identically applied to a description of each of the conductive portion, the elastic portion, and the elastic member included in the connector 830. Hereinafter, a repeated description is omitted.

According to an embodiment, the connector 330 and the connector 830 may be used to connect the antenna substrate 320 and the filter PCB 340. For example, the connector 330 may be contacted with the second area of the antenna substrate 320 and a surface of the filter PCB 340, in a state located in the second area of the antenna substrate 320. For example, the connector 830 may be contacted with the third area of the antenna substrate 320 and a surface of the filter PCB 340, in a state located in the third area of the antenna substrate 320. For example, the filter PCB 340 may have a filter (e.g., the filter 345 of FIG. 3) disposed on the first surface of the filter PCB 340. For example, the connector 330 or the connector 830 may be contacted with a second surface opposite to the first surface of the filter PCB 340. For example, the connector 330 or the connector 830 may be contacted with a conductive portion (e.g., the conductive portion 341 of FIG. 3) of the second surface of the filter PCB 340. For example, the conductive portion of the filter PCB 340 may be a port for transmitting a signal to the antenna elements 310 through the connector 330 (or the connector 830).

According to an embodiment, a plurality of connectors 330 and 830 of the antenna module 800 may be used to provide, to the antenna elements 310 of the antenna module 800, a signal having different polarizations. For example, the connector 330 may be used to provide, to the antenna elements 310, a signal having a first polarization. For example, the connector 830 may be used to provide, to the antenna elements 310, a signal having a second polarization different from the first polarization. For example, in a case that the first polarization is a vertical polarization, the second polarization may be a horizontal polarization. For example, in a case that the first polarization is a clockwise circular polarization, the second polarization may be a counterclockwise circular polarization.

According to an embodiment, the antenna module 800 may include signal lines. For example, the antenna module 800 may include a signal line 826 for connecting each of antenna elements 310 and the connector 330. For example, the signal line 826 may be disposed on the antenna substrate 320. For example, the signal line 826 may be disposed on the second surface of the antenna substrate 320. For example, the signal line 826 may be used to provide, from the connector 330 to each antenna element, the signal having the first polarization for the antenna module 800 to radiate.

According to an embodiment, each of a connector 830 and the antenna elements 310 may be connected through a signal line 827. For example, the signal line 827 may be disposed on the second surface of the antenna substrate 320. For example, the signal line 827 may be used to provide, from the connector 830 to each antenna element, the signal having the second polarization for the antenna module 800 to radiate.

Although not illustrated in FIG. 8, according to an embodiment, a circuit (e.g., a radio frequency integrated circuit (RFIC)) for providing the signal may be disposed on the first surface of the filter PCB 340 included in the antenna module 800. For example, the circuit may be disposed in an area different from an area in which the filter 345 of the first surface of the filter PCB 340 is disposed. Alternatively, according to an embodiment, the antenna module 800 may further include an additional PCB different from the filter PCB 340. For example, the additional PCB may be disposed below the filter PCB 340 of the antenna module 800. For example, the circuit may be disposed on the additional PCB.

Referring to the above description, according to embodiments of the present disclosure, the antenna module 800 including the connector 330 and the connector 830 of the antenna substrate 320 formed of a dielectric and an electronic device (e.g., the base station 110 or an MMU of the base station 110) including the same may electrically connect the filter PCB 340 and the antenna elements 310 without a separate component (e.g., the connector body 243 of FIG. 2B) for connecting with the filter PCB 340 for a signal pin (e.g., the signal pin 241 of FIG. 2B) transmitting the signal. Since an antenna module and an electronic device according to embodiments of the present disclosure do not include the separate component, an SMT process for assembling the separate component on the filter PCB 340 may not be required. Since an antenna module and an electronic device according to embodiments of the present disclosure do not require the separate component, a space for installation may be reduced and a design change of the antenna module may be easy. Since an antenna module and an electronic device according to embodiments of the present disclosure do not require the separate component, a production cost may be reduced.

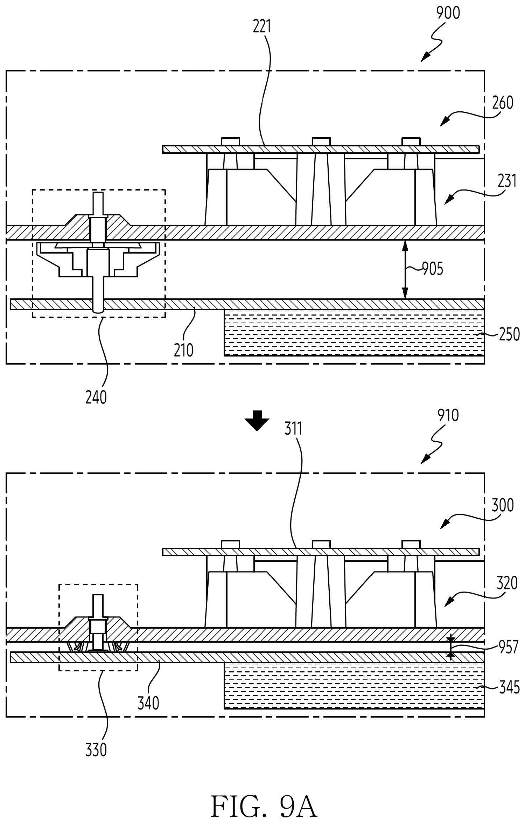

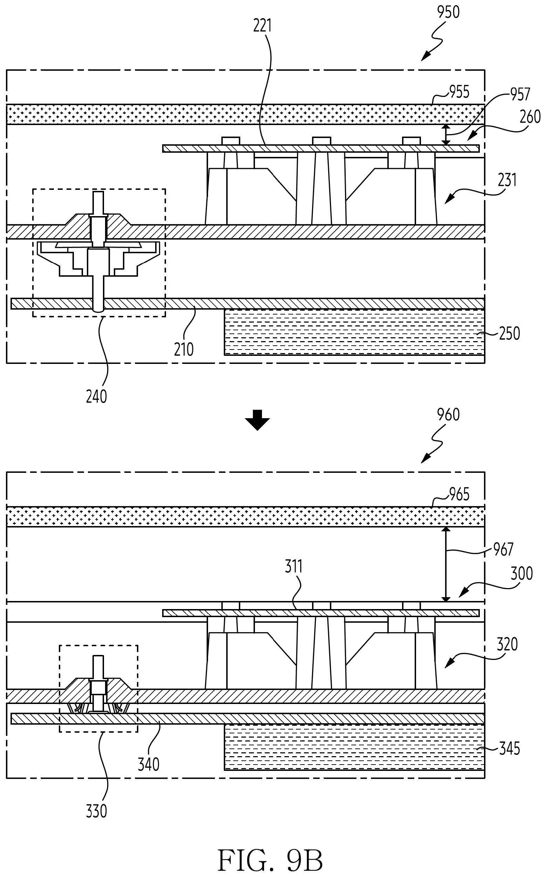

FIG. 9A and FIG. 9B illustrate examples of a connection between an antenna module including a connector using an elastic member and a component according to an embodiment.

FIG. 9A illustrates an example 900 of an electronic device including the antenna module 260 using the connection structure 240 of FIG. 2B and an example 910 of an electronic device including the antenna module 300 of FIG. 3, according to embodiments of the present disclosure.

Referring to FIG. 9A, the electronic device of the example 900 may include a connection structure 240 for connecting a first antenna substrate 231 and a filter PCB 210. For example, the connection structure 240 may provide a signal provided from the filter PCB 210 to an antenna element 221. Since the electronic device of the example 900 connects the first antenna substrate 231 and the filter PCB 210 through the connection structure 240, a relatively large space 905 (or a gap) may be required in design.

In contrast, the electronic device of the example 910 may include a connector 330 for connecting an antenna substrate 320 and a filter PCB 340. For example, the connector 330 may provide a signal provided from the filter PCB 340 to an antenna element 311. Unlike the connection structure 240 including a connector body, since the electronic device of the example 910 uses the connector 330 including a conductive portion (e.g., the conductive portion 331 of FIG. 3) and an elastic portion (e.g., the elastic portion 332 of FIG. 3) (and the elastic member 333), a relatively narrow space 915 (or a gap) may be required in design. In other words, the antenna module 300 according to embodiments of the present disclosure and the electronic device including the same may be miniaturized by using the connector 330 disposed (or formed) in a part of the antenna substrate 320 formed of a dielectric.

FIG. 9B illustrates an example 950 of an electronic device including the antenna module 260 using the connection structure 240 of FIG. 2B and a radome 955 and an example 960 of an electronic device including the antenna module 300 of FIG. 3 according to embodiments of the present disclosure and a radome 965.

Referring to FIG. 9B, the electronic device of the example 950 may include the antenna module 260 including the connection structure 240 and the radome 955. For example, since the electronic device includes the connection structure 240, a gap 957 between the antenna module 260 and the radome 955 may be relatively narrow. In other words, the gap 957 between the antenna element 221 included in the antenna module 260 of the example 950 and the radome 955 may be narrow. Accordingly, components (or an RF component) may be difficult to be further included in the gap 957 between the antenna element 221 and the radome 955.

In contrast, the electronic device of the example 960 may include the antenna module 300 including the connector 330 and the radome 965. For example, since the electronic device includes the connector 330, a gap 967 between the antenna module 300 and the radome 965 may be relatively wide. In other words, the gap 967 between the antenna element 311 included in the antenna module 300 of the example 950 and the radome 965 may be wide. Accordingly, components (or an RF component) may be further included in the gap 967 between the antenna element 311 and the radome 965. For example, the components may include a wall or additional resonators for improving radiation performance of the antenna element 311. For example, the wall or the additional resonators may be disposed between antenna elements. Alternatively, for example, the components may also be disposed between the antenna element 311 and the radome 965.

Referring to the above description, the antenna module 300 according to embodiments of the present disclosure and the electronic device including the same may be miniaturized by using the connector 330. Accordingly, a design change of the antenna module 300 and the electronic device may be easier by using the antenna module 300 according to embodiments of the present disclosure and the electronic device including the same.

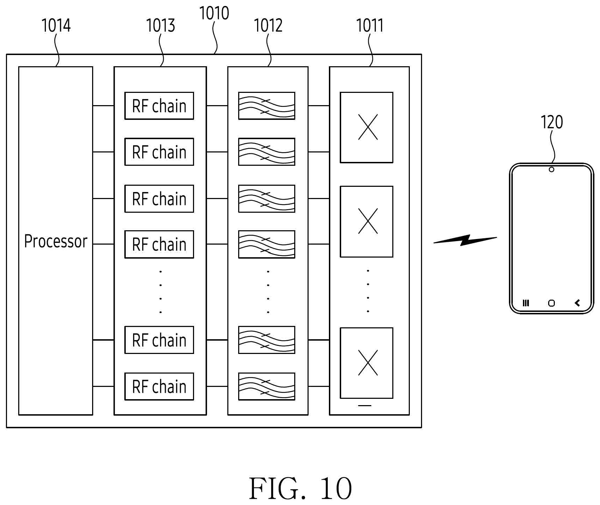

FIG. 10 illustrates examples of components of an electronic device according to an embodiment.

FIG. 10 illustrates a functional configuration of an electronic device 1010 including a connection assembly according to embodiments. The electronic device 1010 may be the base station 110 of FIG. 1 or an MMU (or RU) of the base station 110. Meanwhile, unlike the illustration, it is not excluded that the electronic device 1010 of the present disclosure may also be implemented in a terminal 120. The terminal 120 may be an example of the terminal 120-1, 120-2, or 120-3 of FIG. 1. Not only the structure of the antenna module 300 described through FIG. 3 to FIG. 9B but also an electronic device including the same is included in embodiments of the present disclosure.

Referring to FIG. 10, an exemplary functional configuration of the electronic device 1010 is illustrated. The electronic device 1010 may include an antenna unit 1011, a filter unit 1012, a radio frequency (RF) processing unit 1013, and a control unit 1014.

The antenna unit 1011 may include a plurality of antennas. The antenna performs functions for transmitting and receiving a signal through a wireless channel. The antenna may include a radiator formed of a conductor or a conductive pattern formed on a substrate (e.g., a PCB). The antenna may radiate an up-converted signal on the wireless channel or obtain a signal radiated by another device. Each antenna may be referred to as an antenna element or an antenna device. In some embodiments, the antenna unit 1011 may include an antenna array including a plurality of antenna elements forming an array. The antenna unit 1011 may be electrically connected with the filter unit 1012 through RF signal lines. The antenna unit 1011 may be mounted on a PCB including a plurality of antenna elements. The PCB may include a plurality of RF signal lines connecting each antenna element and a filter of the filter unit 1012. These RF signal lines may be referred to as a feeding network.

According to an embodiment, a connection assembly may be disposed for a stable electrical connection between the antenna unit 1011 and the filter unit 1012. The connection assembly may include, as a signal line, an elastic member for transmitting an RF signal and an elastic member for a ground of the RF signal. The antenna unit 1011 may provide a received signal to the filter unit 1012 or may radiate a signal provided from the filter unit 1012 into air.

The filter unit 1012 may perform filtering to transmit a signal of a desired frequency. The filter unit 1012 may perform a function for selectively identifying a frequency by forming resonance. The filter unit 1012 may include at least one of a band pass filter, a low pass filter, a high pass filter, or a band reject filter. That is, the filter unit 1012 may include RF circuits for obtaining a signal of a frequency band for transmission or a frequency band for reception. The filter unit 1012 according to embodiments may electrically connect the antenna unit 1011 and the RF processing unit 1013.

The RF processing unit 1013 may include a plurality of RF paths. The RF path may be a unit of a path through which a signal received through an antenna or a signal radiated through an antenna passes. At least one RF path may be referred to as an RF chain. The RF chain may include a plurality of RF elements. The RF elements may include an amplifier, a mixer, an oscillator, a DAC, an ADC and the like. For example, the RF processing unit 1013 may include an up converter for up-converting a digital transmission signal of a base band into a transmission frequency, and a digital-to-analog converter (DAC) for converting the up-converted digital transmission signal into an analog RF transmission signal. The up converter and the DAC form a part of a transmission path. The transmission path may further include a power amplifier (PA) or a coupler (or a combiner). In addition, for example, the RF processing unit 1013 may include an analog-to-digital converter (ADC) for converting an analog RF reception signal into a digital reception signal and a down converter for converting a digital reception signal into a digital reception signal of a base band. The ADC and the down converter form a part of a reception path. The reception path may further include a low-noise amplifier (LNA) or a coupler (or a divider). RF components of the RF processing unit may be implemented on a PCB. The base station 1010 may include a structure stacked in an order of the antenna unit 1011-the filter unit 1012-the RF processing unit 1013. The antennas and RF components of the RF processing unit may be implemented on a PCB, and filters may be repeatedly fastened between PCBs to form a plurality of layers.

The control unit 1014 may control overall operations of the electronic device 1010. The control unit 1014 may include various modules for performing communication. The control unit 1014 may include at least one processor such as a modem. The control unit 1014 may include modules for digital signal processing. For example, the control unit 1014 may include a modem. When transmitting data, the control unit 1014 may generate complex symbols by encoding and modulating a transmission bit string. In addition, for example, when receiving data, the control unit 1014 may restore a reception bit string through demodulating and decoding of a baseband signal. The control unit 1014 may perform functions of a protocol stack required in a communication standard.

In FIG. 10, a functional configuration of the electronic device 1010 has been described as equipment in which the antenna structure of the present disclosure may be utilized. However, the example illustrated in FIG. 10 is merely an exemplary configuration for utilization of the antenna structure according to various embodiments of the present disclosure described through FIG. 3 to FIG. 9B, and embodiments of the present disclosure are not limited to components of the equipment illustrated in FIG. 10. Accordingly, an antenna module including the antenna structure, communication equipment of another configuration, and an antenna structure itself may also be understood as an embodiment of the present disclosure.

Referring to the above description, according to embodiments of the present disclosure, a connector of an antenna substrate formed of a dielectric, an antenna module including the connector, and an electronic device (e.g., the base station 110 or an MMU of the base station 110) including the same may electrically connect a filter PCB and antenna elements without a separate component (e.g., the connector body 243 of FIG. 2B) for connecting with the filter PCB 340 for a signal pin (e.g., the signal pin 241 of FIG. 2B) transmitting the signal. Since the antenna module and the electronic device according to embodiments of the present disclosure do not include the separate component, an SMT process for assembling the separate component on a filter PCB may not be required. Since an antenna module and an electronic device according to embodiments of the present disclosure do not require the separate component, a space for installation may be reduced and a design change of the antenna module may be easy. Since an antenna module and an electronic device according to embodiments of the present disclosure do not require the separate component, a production cost may be reduced.

The effects that can be obtained from the present disclosure are not limited to those described above, and any other effects not mentioned herein will be clearly understood by those having ordinary knowledge in the art to which the present disclosure belongs, from the following description.

As described above, an antenna module may include an antenna substrate, formed of a dielectric and including a first area in which a plurality of antenna elements are disposed. The antenna module may include a printed circuit board (PCB) including a first surface on which a filter is disposed. The antenna module may include a connector between the antenna substrate and the PCB, disposed in a second area different from the first area of the antenna substrate, and penetrating the second area of the antenna substrate. The connector may include a conductive portion for connecting the plurality of antenna elements and the PCB and providing a signal to the plurality of antenna elements, and an elastic portion surrounding the conductive portion. The conductive portion may be contacted with a second surface opposite to the first surface of the PCB.

According to an embodiment, the connector may include an elastic member included in the conductive portion. While a gap between the PCB and the antenna substrate is reduced, the elastic member may be compressed.

According to an embodiment, the antenna module may further include another connector disposed in a third area different from the first area and the second area of the antenna substrate. The another connector may include another conductive portion for connecting the plurality of antenna elements and the PCB and providing another signal to the plurality of antenna elements, and another elastic portion surrounding the another conductive portion. The another conductive portion may be contacted with the second surface of the PCB.

According to an embodiment, the signal provided through the connector may have a first polarization. The another signal provided through the another connector may have a second polarization different from the first polarization.

According to an embodiment, the antenna substrate may include a conductive surface in the antenna substrate. The elastic portion of the connector may be connected with the conductive surface. The elastic portion may be used to provide a ground of the antenna module.

According to an embodiment, the antenna module may further include a signal line connecting each of the plurality of antenna elements and the connector. The signal line may be disposed on a second surface of the antenna substrate, opposite to the first surface of the antenna substrate disposed close to the PCB. The signal line may provide the signal to each of the plurality of antenna elements.

According to an embodiment, the elastic portion may be configured in the antenna substrate through injection or press fit, or may be attached to the antenna substrate through an adhesive.

According to an embodiment, the connector may be configured in the second area of the antenna substrate through injection or press fit.

According to an embodiment, a thickness of the antenna substrate of the first area may be thicker than a thickness of the antenna substrate of the second area.

According to an embodiment, the antenna module may be formed above the antenna substrate. The antenna module may further include an RF component disposed between the plurality of antenna elements.

As described above, a device of a base station may include a plurality of antenna modules. The device of the base station may include a plurality of filters corresponding to the plurality of antenna modules. Each of the plurality of antenna modules may include an antenna substrate, formed of a dielectric, including a first area in which a plurality of antenna elements are disposed. Each of the plurality of antenna modules may include a printed circuit board (PCB) including a first surface on which a filter among the plurality of filters is disposed. Each of the plurality of antenna modules may include a connector between the antenna substrate and the PCB, disposed in a second area different from the first area of the antenna substrate, and penetrating the antenna substrate of the second area. The connector may include a conductive portion for connecting the plurality of antenna elements and the PCB and providing a signal to the plurality of antenna elements, and an elastic portion surrounding the conductive portion. The conductive portion may be contacted with a second surface opposite to the first surface of the PCB.

According to an embodiment, the connector may include an elastic member included in the conductive portion. While a gap between the PCB and the antenna substrate is reduced, the elastic member may be compressed.

According to an embodiment, the antenna module may further include another connector disposed in a third area different from the first area and the second area of the antenna substrate. The another connector may include another conductive portion for connecting the plurality of antenna elements and the PCB and providing another signal to the plurality of antenna elements, and another elastic portion surrounding the another conductive portion. The another conductive portion may be contacted with the second surface of the PCB.

According to an embodiment, the signal provided through the connector may have a first polarization. The another signal provided through the another connector may have a second polarization different from the first polarization.

According to an embodiment, the antenna substrate may include a conductive surface in the antenna substrate. The elastic portion of the connector may be connected with the conductive surface. The elastic portion may be used to provide a ground of the antenna module.

According to an embodiment, the antenna module may further include a signal line connecting each of the plurality of antenna elements and the connector. The signal line may be disposed on a second surface of the antenna substrate, opposite to the first surface of the antenna substrate disposed close to the PCB. The signal line may provide the signal to each of the plurality of antenna elements.

According to an embodiment, the elastic portion may be configured in the antenna substrate through injection or press fit, or may be attached to the antenna substrate through an adhesive.

According to an embodiment, the connector may be configured in the second area of the antenna substrate through injection or press fit.

According to an embodiment, a thickness of the antenna substrate of the first area may be thicker than a thickness of the antenna substrate of the second area.

According to an embodiment, the antenna module may be formed above the antenna substrate. The antenna module may further include an RF component disposed between the plurality of antenna elements.

Methods according to embodiments described in claims or specifications of the present disclosure may be implemented as a form of hardware, software, or a combination of hardware and software.

In a case of implementing as software, a computer-readable storage medium for storing one or more programs (software module) may be provided. The one or more programs stored in the computer-readable storage medium are configured for execution by one or more processors in an electronic device. The one or more programs include instructions that cause the electronic device to execute the methods according to embodiments described in claims or specifications of the present disclosure. The one or more programs may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. In the case of being distributed online, at least part of the computer program product may be temporarily generated or at least temporarily stored in the machine-readable storage medium, such as memory of the manufacturer's server, the application store's server, or a relay server.

Such a program (software module, software) may be stored in a random access memory, a non-volatile memory including a flash memory, a read only memory (ROM), an electrically erasable programmable read only memory (EEPROM), a magnetic disc storage device, an optical storage device (e.g., a compact disc-ROM (CD-ROM), digital versatile discs (DVDs), or other formats), or a magnetic cassette. Alternatively, it may be stored in memory configured with a combination of some or all of them. In addition, a plurality of configuration memories may be included.

Additionally, a program may be stored in an attachable storage device that may be accessed through a communication network such as the Internet, Intranet, local area network (LAN), wide area network (WAN), or storage area network (SAN), or a combination thereof. Such a storage device may be connected to a device performing an embodiment of the present disclosure through an external port. In addition, a separate storage device on the communication network may also be connected to a device performing an embodiment of the present disclosure.

In the above-described specific embodiments of the present disclosure, components included in the disclosure are expressed in the singular or plural according to the presented specific embodiment. However, the singular or plural expression is selected appropriately according to a situation presented for convenience of explanation, and the present disclosure is not limited to the singular or plural component, and even components expressed in the plural may be configured in the singular, or a component expressed in the singular may be configured in the plural.

According to various embodiments, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be executed sequentially, in parallel, repeatedly, or heuristically, or one or more of the operations may be executed in a different order or omitted, or one or more other operations may be added.

Meanwhile, specific embodiments have been described in the detailed description of the present disclosure, and of course, various modifications are possible without departing from the scope of the present disclosure.

## Claims

1. An antenna module comprising:
an antenna substrate, which is formed of a dielectric, including a first area where a plurality of antenna elements are disposed;
a printed circuit board (PCB) including a first surface where a filter is disposed; and
a connector, disposed on a second area different from the first area of the antenna substrate and penetrating the second area of the antenna substrate, between the PCB and the antenna substrate,
wherein the connector includes:
a conductive portion, connecting the plurality of antenna elements and the PCB, providing a signal to the plurality of antenna elements; and
an elastic portion surrounding the conductive portion; and
wherein the conductive portion is contacted to a second surface opposite to the first surface of the PCB.

2. The antenna module of claim 1,
wherein the connector includes an elastic member included in the conductive portion, and
wherein the elastic member is compressed while a gap between the PCB and the antenna substrate is reduced.

3. The antenna module of claim 1,
wherein the antenna module further comprises another connector disposed on a third area different from the first area and the second area of the antenna substrate,
wherein the another connector includes:
another conductive portion, connecting the plurality of antenna elements and the PCB, providing another signal to the plurality of antenna elements; and
another elastic portion surrounding the another conductive portion, and
wherein the another conductive portion is contacted to the second surface opposite of the PCB.

4. The antenna module of claim 3,
wherein the signal provided through the connector has a first polarization, and
wherein the another signal provided through the another connector has a second polarization different from the first polarization.

5. The antenna module of claim 1,
wherein the antenna substrate includes a conductive surface in the antenna substrate,
wherein the elastic portion of the connector is coupled to the conductive surface, and
wherein the elastic portion is used to provide ground of the antenna module.

6. The antenna module of claim 1,
wherein the antenna module further includes a signal line connecting the connector and each of the plurality of antenna elements,
wherein the signal line is disposed on a second surface of the antenna substrate opposite to the first surface of the antenna substrate, and
wherein the signal line provides the signal to each of the plurality of antenna elements.

7. The antenna module of claim 1,
wherein the elastic portion is configured using injection or press fit in the antenna substrate or is attached to the antenna substrate through an adhesive.

8. The antenna module of claim 1,
wherein the connector is configured using injection or press fit in the second area of the antenna substrate.

9. The antenna module of claim 1,
wherein a thickness of the antenna substrate of the first area is thicker than a thickness of the antenna substrate of the second area.

10. The antenna module of claim 1,
wherein the antenna module is formed above the antenna substrate, and
wherein the antenna module further includes a radio frequency (RF) component disposed between the plurality of antenna elements.

11. A device of a base station comprising:
a plurality of antenna modules; and
a plurality of filters corresponding to the plurality of antenna modules,
wherein each of the plurality of antenna modules includes:
an antenna substrate, which is formed of a dielectric, including a first area where a plurality of antenna elements are disposed;
a printed circuit board (PCB) including a first surface where a filter among the plurality of filters is disposed; and
a connector, disposed on a second area different from the first area of the antenna substrate and penetrating the second area of the antenna substrate, between the PCB and the antenna substrate,
wherein the connector includes:
a conductive portion, connecting the plurality of antenna elements and the PCB, providing a signal to the plurality of antenna elements; and
an elastic portion surrounding the conductive portion; and
wherein the conductive portion is contacted to a second surface opposite to the first surface of the PCB.

12. The device of claim 11,
wherein the connector includes an elastic member included in the conductive portion, and
wherein the elastic member is compressed while a gap between the PCB and the antenna substrate is reduced.

13. The device of claim 11,
wherein each of the plurality of antenna modules further comprise another connector disposed on a third area different from the first area and the second area of the antenna substrate,
wherein the another connector includes:
another conductive portion, connecting the plurality of antenna elements and the PCB, providing another signal to the plurality of antenna elements; and
another elastic portion surrounding the another conductive portion, and
wherein the another conductive portion is contacted to the second surface opposite of the PCB.

14. The device of claim 13,
wherein the signal provided through the connector has a first polarization, and
wherein the another signal provided through the another connector has a second polarization different from the first polarization.

15. The device of claim 11,
wherein the antenna substrate includes a conductive surface in the antenna substrate,
wherein the elastic portion of the connector is coupled to the conductive surface, and
wherein the elastic portion is used to provide ground of the antenna module.
